# EUROPEAN PATENT APPLICATION

(11) **EP 2 533 062 A1**
(43) Date of publication of application: **12.12.2012**
(21) Application number: 11290268.9
(22) Date of filing: 10.06.2011
(51) Int. Cl.: G01R 31/3167, G01R 31/317

(54) **A radio frequency integrated circuit**

(71) Applicant: NXP B.V., 5656 AG Eindhoven (NL)
(72) Inventor: Lefevre, Francois, Redhill Surrey RH1 1DL (GB); Haize, Stephane, Redhill Surrey RH1 1DL (GB); Taffu, Lionel, Redhill Surrey RH1 1DL (GB)
(74) Representative: Williamson, Paul Lewis

(57) **Abstract**

A radio frequency integrated circuit (100) having a self test mode of operation. The integrated circuit (100) comprising a first pin (104) and a second pin (108). The integrated circuit (100) also comprises an internal testing component (102) coupled to the first pin (104); and an internal processing component (106) coupled to the second pin (108). The first pin (104) is couplable to the second pin (108) externally in order to utilise the internal testing component (102) in testing the internal processing component (106) in the self test mode of operation.

## Description

The present disclosure relates to the field of radio frequency integrated circuits and methods of operating radio frequency integrated circuits, and particularly, although not exclusively, radio frequency integrated circuits having a self test mode of operation.

Semiconductor companies are constantly looking for methods to decrease the production test costs of semiconductor devices. For complex radio frequency (RF) integrated circuits (ICs), such as silicon tuners, a lot of time-consuming RF tests may be performed to check the specification and functionality of the IC. This can lead to long test times and therefore high production costs. Also the possibility of testing several ICs in parallel at the same time (so called multi-site testing) may be limited by the number of resources of the test equipment The multi-site technique can help to reduce the test time per device under test but requires costly testers equipped with many resources. Moreover complex RF products require expensive RF resources (source and detector units) to execute a test list compatible with customer quality needs.

Built-In-Self-Test (BIST) strategies are known and can be preferred to using external testers when testing high performance mixed-signal and RF products, such as integrated circuits (ICs). This can reduce the cost of production test and avoid using expensive testers. As its name indicates, a BIST requires that the IC generates the test signal and performs the detection internally, without any external source or detection equipment. This requires the internal connection of the IC source to the input, and the internal detector to the output for each block or group of blocks that are to be tested.

The listing or discussion of a prior-published document or any background in the specification should not necessarily be taken as an acknowledgement that the document or background is part of the state of the art or is common general knowledge.

According to a first aspect of the invention, there is provided a radio frequency integrated circuit having a self test mode of operation, the integrated circuit comprising:
a first pin;
a second pin;
an internal testing component coupled to the first pin; and
an internal processing component coupled to the second pin;
wherein the first pin is couplable to the second pin externally of the integrated circuit in order to utilise the internal testing component in testing the internal processing component in the self test mode of operation.

Such an integrated circuit can be used to incorporate the internal processing component into a self test, without requiring internal links which would otherwise detract from the performance of the device. This can be particularly advantageous where the internal processing component is a sensitive component/block. The use of self testing can avoid a need for external testing equipment, which can increase the complexity and cost in testing the device.

The radio frequency integrated circuit may be monolithic, and/or may be a silicon tuner. The silicon tuner may be for a television set. The internal processing component may be an input or output radio frequency block. Such devices and components can have particular requirements for testing that cannot be readily met with the prior art.

The internal processing component may be an input low noise amplifier and the internal testing component may be a calibration oscillator. The internal processing component may be an output intermediate frequency amplifier and the internal testing component may be a calibration detector or a Received Signal Strength Indicator used for application purpose.

The integrated circuit may further comprise an application functionality component. The first pin may be couplable to the internal testing component when the integrated circuit is in the self test mode of operation. The first pin may be couplable to the application functionality component when the integrated circuit is not in the self test mode of operation. In this way, an additional pin on the integrated circuit is not required, and this can be particularly advantageous for pin-limited integrated circuits.

The integrated circuit may further comprise a switch configured to couple the first pin to the internal testing component or the application functionality component in accordance with the mode of operation of the integrated circuit.

Alternatively, the first pin may be a dedicated test pin. The first pin may not have any significant functionality when the integrated circuit is not in the test mode of operation.

The integrated circuit may further comprise:
a third pin;
a fourth pin;
a second internal testing component coupled to the third pin of the integrated circuit; and
a second internal processing component coupled to the fourth pin;
wherein the fourth pin of the integrated circuit is couplable to the third pin externally in order to utilise the second internal testing component in testing the second internal processing component in the self test mode of operation.

Such an integrated circuit can enable two internal processing components to be included in the self test, possibly at the same time. In one example, an input internal processing component and an output internal processing component can be included in a self test.

In examples where the internal processing component is an input low noise amplifier and the internal testing component is a calibration oscillator. The second internal processing component may be an output intermediate frequency amplifier and the second internal testing component may be a calibration detector.

The integrated circuit may further comprise an application functionality component. The third pin may be couplable to the second internal testing component when the integrated circuit is in the self test mode of operation. The third pin may be couplable to the application functionality component when the integrated circuit is not in the self test mode of operation.

The integrated circuit may further comprise a switch configured to couple the third pin to the second internal testing component or the application functionality component in accordance with the mode of operation of the integrated circuit.

Alternatively, the third pin may be a dedicated test pin.

The integrated circuit may comprise a plurality of internal processing components, wherein each of the plurality of internal processing components is associated with a pin of the integrated circuit, and wherein one or more of the associated pins are couplable to the second pin externally of the integrated circuit in order to utilise the associated internal testing component in the self test mode of operation.

One or more of the associated pins and in some examples a subset of the associated pins, may be connectable to the second pin by a switch. One or more of the associated pins, and in some examples a subset of the associated pins, may be connectable to the second pin by a splitter. There may be provided a system comprising any integrated circuit disclosed herein and such a switch and/or splitter.

The integrated circuit may further comprise a switch that is configured to operably connect the output of the internal testing component to either: (i) the input of any internal block/component so that an internal self test can be performed; or (ii) the first pin.

According to a further aspect of the invention, there is provided a method of performing a self test on any integrated circuit disclosed herein, the method comprising:
coupling the first pin to the second pin; and
selecting the self test mode of operation for the integrated circuit.

A description is now given, by way of example only, with reference to the accompanying drawings, in which:
Figure 1 illustrates a radio frequency (RF) integrated circuit according to an embodiment of the invention;
Figure 2 illustrates an integrated circuit according to another embodiment of the invention;
Figure 3 illustrates an integrated circuit according to another embodiment of the invention;
Figure 4 illustrates an integrated circuit according to an embodiment of the invention that uses a test pin that is multiplexed with application functionality.

One or more embodiments described herein relate to a radio frequency integrated circuit that has a self test mode of operation. The integrated circuit has an internal testing component coupled to a first pin of the integrated circuit and an internal processing component coupled to a second pin of the integrated circuit. The first pin of the integrated circuit is couplable to the second pin externally of the integrated circuit in order to utilise the internal testing component in testing the internal processing component in the self test mode of operation.

Such an integrated circuit can avoid coupling the two components internally, within the integrated circuit, which can lead to unacceptable performance for sensitive components. The integrated circuit can also avoid the need for using external testing equipment that would otherwise be required to test components that cannot be included in an internal test circuit.

Built-In-Self-Test (BIST) techniques require the control of the input and the output of blocks/internal components under test. For sensitive blocks, such as a low noise amplifier (LNA), this is not possible as the sensitive component cannot tolerate the additional internal links and switches or multiplexers that would be required to operably include and exclude the sensitive component in the internal BIST circuit. Use of such an internal loopback for sensitive components would decrease the performance of the device and so may not satisfy application and design constraints of some ICs. For example, the additional impedance and noise that would be introduced can be unacceptable. Therefore, sensitive blocks (such as LNAs) are not included in Built-In-Self-Test strategies, and external testing equipment must be used to test these components.

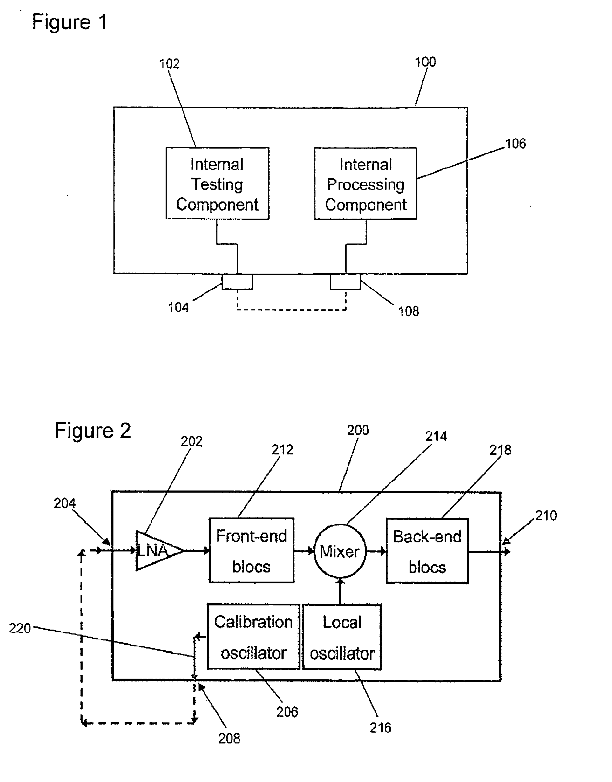

Figure 1 illustrates a radio frequency (RF) integrated circuit 100 according to an embodiment of the invention. The integrated circuit 100 has an internal testing component 102 coupled to a first pin 104 of the integrated circuit 100. The internal testing component 102 is used in a self test mode of operation of the integrated circuit 100 in order to provide a test signal to an internal component/block in the integrated circuit or detect the results of the test procedure, for example. The first pin 104 may also be referred to as a test pin.

The integrated circuit 100 also has an internal processing component 106 coupled to a second pin 108 of the integrated circuit 100. The internal processing component 106 can be any component or block. In some examples the internal processing component 106 is a sensitive component that cannot be included in an internal loopback for self testing.

According to this example of the invention, the first pin 104 of the integrated circuit 100 is couplable to the second pin 108 externally in order to utilise the internal testing component 102 in testing the internal processing component 106 in the self test mode of operation. The first pin 104 and second pin 108 can be coupled by any external link such as a track on a printed circuit board (PCB) or by any other means.

In some examples the external link can include a switch so as to be able to disconnect the first pin 104 from the second pin 108 when testing is not required.

Advantageously, the integrated circuit 100 of Figure 1 can be used to include the internal processing component 106 in a self test mode of operation without requiring any internal links to the input of the internal processing component 106. Such internal links can lead to unacceptable performance with sensitive components. Furthermore, a requirement for external test equipment can be reduced and/or avoided.

According to an embodiment of the invention, an internal test signal that is available for a BIST strategy can be made available externally on a pin of an IC. Those skilled in the art of Design for Test can determine a preferred pin arrangement depending on the number of pin available and the pinning constraints. Once the internal test signal is made available outside the IC, it can be easy to connect it to the input of a sensitive block so that the sensitive block can be included in the BIST loop.

Figure 2 illustrates a integrated circuit according to another embodiment of the invention. In this embodiment, the integrated circuit is a silicon tuner IC 200 for a television set. The IC 200 has a low noise amplifier (LNA) 202, the input of which is connected to a first pin 204. The LNA 202 is an example of a sensitive component that cannot be included in an internal test loop due to its intolerance to the additional internal test loop that would be required. The output of the LNA 202 is connected to one or more components that are referred to as front-end blocs 212 in Figure 2. The output signal from the front-end blocs 212 is mixed with a signal from a local oscillator 216 by a mixer 214. The mixer 214 output is provided to one or more components that are referred to as back-end blocs 218 in Figure 2. The output signal from the back-end blocs is provided to a pin 210 on the IC 200.

The IC 200 also includes a calibration oscillator 206 that provides a test signal 220 on a second pin 208 of the IC package for test purposes. By exposing the test signal in this way, an external connection can provide a link that enables the test signal 220 to be provided to the input of the LNA 202 at the first pin 204. The external connection can be a wire on a PCB, a cable or any means that is used by those skilled in the art of PCB design. The choice of external connection can also depend on product constraints such as frequency, noise, etc.

An advantage of this embodiment of the invention is that no design modification is required for the LNA 202. Therefore this block/component can be fully optimized for its intended application purpose yet still be included in a self test.

In some examples, a switch may be provided to operably connect the output of the calibration oscillator to either: (i) the input of the front-end blocs (or the input of any internal block/component) so that an internal BIST can be used; or (ii) the test pin 208 so that an external loopback can be used.

It can be advantageous to use a test pin 208 which is located as close as possible to the sensitive block 202 in order to minimize the length of the external loopback.

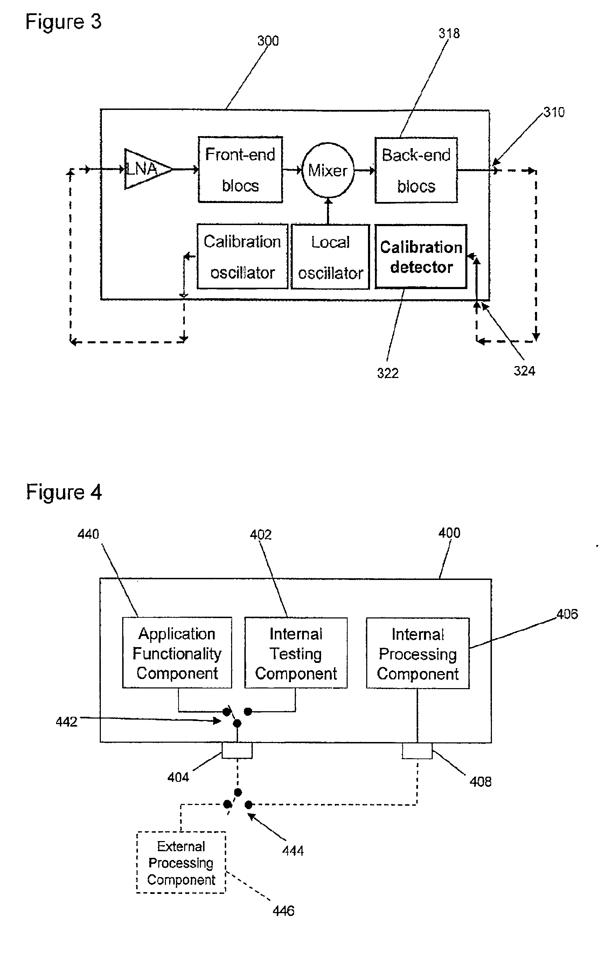

Figure 3 illustrates a integrated circuit 300 according to another embodiment of the invention. The integrated circuit 300 of Figure 3 is similar to the integrated circuit of Figure 2. Components that are common to both Figures 2 and 3 will not be described again here.

The integrated circuit 300 of Figure 3 includes a calibration detector 322 that is used to detect the results of a self test of the internal components of the integrated circuit 300. In one example, the calibration detector 322 may determine a Receive Signal Strength Indicator (RSSI). In this embodiment, the calibration detector 322 is coupled to a third pin 324 of the integrated circuit 300 in order to receive signals for processing as part of the detection.

The back-end blocs 318 of Figure 3 are connected to a fourth pin 310 of the integrated circuit 300, and can include sensitive components that cannot be included in an internal test loop within the integrated circuit 300. An example of a sensitive component that may be present in the back-end blocs 318 is an intermediate frequency (IF) amplifier.

In a similar way to that described above in relation to Figure 2, an external connection can provide a link between the output of the back-end blocs 318 at the fourth pin 204 and the input to the calibration detector 322 at the third pin 324. In this way, signals that have been processed by the back-end blocs 318 can also be included in the self test circuit.

It will be appreciated that the external connection between the third pin 324 and fourth pin 310 can be in addition to, or instead of, the external connection between the first pin and second pin that is described in relation to Figure 2. In examples where two external connections are used, this can enable the full receive chain (or any other functionality that is provided by an integrated circuit) to be tested without requiring external RF test equipment.

The embodiment of Figure 2 relates to a silicon tuner and its LNA, which is an example of a receiver and its sensitive input. The embodiment of Figure 3 relates to a silicon tuner and its back-end blocs, which is an example of a receiver and its sensitive output. Those skilled in the art of design and architecture will readily understand that embodiments of the invention can be used with inputs or outputs, and with many different types of products such as a receiver, a transmitter, or a transceiver.

Embodiments of the invention use a pin on a integrated circuit that is used to expose a terminal of a testing component (such as a calibration oscillator or a calibration detector) in order to build an external loopback with a sensitive block within the integrated circuit. The pin can be a dedicated test pin or the pin can be multiplexed with a functional pin used by an application that is provided by the integrated circuit. Specific test modes can be defined to control the test pin according to embodiments of the invention.

In examples that use a dedicated test pin, the test mode may switch the pin on or off to avoid disturbance when the IC is providing its application functionality. However, as the test pin is dedicated this may not be compulsory.

Figure 4 illustrates an embodiment of an integrated circuit 400 that uses a test pin 404 that is multiplexed with application functionality.

The integrated circuit 400 of Figure 4 includes an internal testing component 402 and an internal processing component 406. The internal processing component 406 may be a sensitive component that cannot be included in an internal test loop. The integrated circuit 400 also includes an application functionality component 440 that represents any internal processing component that is connected to a pin of the integrated circuit 400 when it is operating in a normal mode of operation; that is, it is not in a test mode of operation.

The integrated circuit 400 includes an internal switch 442 that is configured to couple either the application functionality component 440 or the internal testing component 402 to the test pin 404 in accordance with the mode of operation of the integrated circuit 400. In this way, no additional pins are required to include the internal processing component 406 in a self test loop. This can be a significant advantage for pin-limited integrated circuits.

The test mode can control the switch 442 in order to change the functionality of the test pin 404 between the test mode and the functional mode. When the test mode is selected the pin 404 will be connected with the loopback for BIST purpose. When the test mode is not selected the pin 404 works as required by the application. No specific change may be needed for the internal processing block 406 when in the test mode, although it will be appreciated that a designer may add specific programming for test purpose without departing from the current invention. A pin can be selected that has functionality that is not needed during the BIST and the loopback test set-up.

There may also be provided an external switch 444 connected to the test pin 404. The external switch 444 can couple the test pin 404 to either the second pin 408 or an external processing component 446 in accordance with the mode of operation of the integrated circuit 400.

The internal switch 442, or the external switch 442, or both, may be a multiplexer.

It will be appreciated that if two test pins are used, such as the example illustrated in Figure 3, then both of the test pins can be multiplexed with application functionality components.

Any of the integrated circuits disclosed herein could include a plurality of internal processing components, such as a plurality of LNA's and/or IF amplifiers. Each of the plurality of internal processing components can be associated with a separate pin of the integrated circuit. One or more of the associated separate pins are couplable to the second pin externally of the integrated circuit in order to utilise the associated internal testing component in the self test mode of operation. This may be useful to include a number of LNA's in the self test loop in parallel, for example.

This example could also include a switch and or a splitter external of the integrated circuit in order to connect one or more of the separate pins, and in some examples a subset of the separate pins, to the second pin.

A self test on any integrated circuit disclosed herein can be performed according to an embodiment of the invention by coupling the first pin to the second pin, and selecting the self test mode of operation for the integrated circuit. In this way, a signal from an internal testing component can be provided to an internal testing component (or vice versa) in order to include the internal processing component in the self test without requiring any external testing equipment.

Embodiments of the present invention can target any sensitive block that should be included in a Built-In-Self-Test strategy but cannot be included in an internal loopback. It can be applicable to any silicon tuner and specifically to an LNA which is very sensitive. In order to test the LNA without any expensive external equipment, a secondary oscillator that is used for calibration purposes can be output on a pin such that it can be connected externally to the LNA. In this way, a Built-In-Self-Test can be performed using an external loopback.

Embodiments of the invention may also be used to test an IF amplifier in a silicon tuner by enabling the signal power to be determined after the signal has been processed by the IF amplifier. In the prior art, an RSSI that is used for the BIST can only be based upon the signal power before the IF amplifier. Therefore, adding a specific test input to connect externally the IF amplifier output to the RSSI input can enable the IF amplifier to be included in the BIST strategy.

A silicon tuner according to an embodiment of the invention can be tested extensively, without expensive external RF equipment, by including all of an integrated circuits internal blocs in the BIST strategy. This can avoid the need for an expensive industrial tester (Automated Test Equipment). Therefore, RF products can be tested in production on a simple low cost tester. Furthermore, as limited tester resources are required, more integrated circuits can be tested in parallel (so called multisite testing) such that a further reduction in the cost and complexity can be achieved.

A further advantage of integrated circuits according to an embodiment of the invention is that the electrical connection between the pin of the integrated circuit and the external link can also be included as part of the test routine. This can be particularly advantageous for examples such as that illustrated as Figure 4 because the connection between the pin 404 and the external switch 444 is the same for the test mode and the normal mode of operation. For embodiments where the integrated circuit is an IC that is soldered onto a PCB, any substandard soldering between the test pin and the PCB can be identified as part of the self test of the IC.

Embodiments of the invention can be applied to any silicon tuner, for example a silicon tuner for a television front end. Embodiments can also be used with any integrated circuit or device that includes sensitive blocs/components.

## Claims

1. A radio frequency integrated circuit (100) having a self test mode of operation, the integrated circuit (100) comprising:
a first pin (104);
a second pin (108);
an internal testing component (102) coupled to the first pin (104); and
an internal processing component (106) coupled to the second pin (108);
wherein the first pin (104) is couplable to the second pin (108) externally of the integrated circuit (100) in order to utilise the internal testing component (102) in testing the internal processing component (106) in the self test mode of operation.

2. The integrated circuit (100) of claim 1, wherein the radio frequency device is a monolithic integrated circuit:

3. The integrated circuit (100) of claim 1 or claim 2, wherein the radio frequency integrated circuit is a silicon tuner.

4. The integrated circuit (100) of any preceding claim, wherein the internal processing component (106) is an input or output radio frequency block.

5. The integrated circuit (200) of any preceding claim, wherein the internal processing component is an input low noise amplifier (202) and the internal testing component is a calibration oscillator (206).

6. The integrated circuit (300) of any one of claims 1 to 4, wherein the internal processing component is an output intermediate frequency amplifier (318) and the internal testing component is a calibration detector (322).

7. The integrated circuit (400) of any preceding claim, further comprising an application functionality component (440), and wherein the first pin (404) is couplable to the internal testing component (402) when the integrated circuit (400) is in the self test mode of operation and is couplable to the application functionality component (440) when the integrated circuit (400) is not in the self test mode of operation.

8. The integrated circuit (400) of claim 7, further comprising a switch (442) configured to couple the first pin (404) to the internal testing component (402) or the application functionality component (440) in accordance with the mode of operation of the integrated circuit (400).

9. The integrated circuit (100) of any one of claims 1 to 6, wherein the first pin is a dedicated test pin.

10. The integrated circuit (300) of any preceding claim, further comprising:
a third pin (324);
a fourth pin (310);
a second internal testing component (322) coupled to the third pin (324); and
a second internal processing component (318) coupled to the fourth pin (310);
wherein the fourth pin (310) is couplable to the third pin (324) externally in order to utilise the second internal testing component (322) in testing the second internal processing component (318) in the self test mode of operation.

11. The integrated circuit (300) of claim 10, as it depends directly or indirectly from claim 5, wherein the second internal processing component is an output intermediate frequency amplifier (318) and the second internal testing component is a calibration detector (322).

12. The integrated circuit of claim 10 or claim 11, further comprising an application functionality component, wherein the third pin is couplable to the second internal testing component when the integrated circuit is in the self test mode of operation and is couplable to the application functionality component when the integrated circuit is not in the self test mode of operation.

13. The integrated circuit of claim 12, further comprising a switch configured to couple the third pin to the second internal testing component or the application functionality component in accordance with the mode of operation of the integrated circuit.

14. The integrated circuit of any preceding claim, further comprising a plurality of internal processing components, wherein each of the plurality of internal processing components is associated with a pin of the integrated circuit, and wherein one or more of the associated pins are couplable to the second pin externally of the integrated circuit in order to utilise the associated internal testing component in the self test mode of operation.

15. A method of performing a self test on a integrated circuit according to any of the preceding claims, the method comprising:
coupling the first pin to the second pin; and
selecting the self test mode of operation for the integrated circuit.
